# EUROPÄISCHE PATENTSCHRIFT

(11) **EP 1 183 919 B1**
(45) Veröffentlichungstag und Bekanntmachung des Hinweises auf die Patenterteilung: **27.11.2002**
(21) Anmeldenummer: 00940199.3
(22) Anmeldetag: 17.05.2000
(51) Int. Cl.: H05K 7/20

(54) **VORRICHTUNG ZUR ENTWÄRMUNG EINES IN EINEM GEHÄUSE BEFESTIGTEN ELEKTRONISCHEN BAUTEILS**
DEVICE FOR DISSIPATING HEAT FROM AN ELECTRONIC COMPONENT SITUATED IN A HOUSING
DISPOSITIF POUR DISSIPER LA CHALEUR A PARTIR D'UN COMPOSANT ELECTRONIQUE FIXE DANS UN BOITIER

(30) Priorität: 31.05.1999 DE 19924957
(43) Veröffentlichungstag der Anmeldung: 06.03.2002
(73) Patentinhaber: SIEMENS AKTIENGESELLSCHAFT, 80333 München (DE)
(72) Erfinder: JUNG, Robert, D-92245 Kümmersbruck (DE); KREUTZER, Rainer, D-92637 Weiden (DE); ZERBIAN, Erich, D-92269 Fensterbach (DE)
(86) Internationale Anmeldenummer: DE0001569
(87) Internationale Veröffentlichungsnummer: WO00074456

(56) Entgegenhaltungen:
- DE-A- 2 722 142
- DE-A- 3 710 198
- GB-A- 2 178 243
- US-A- 4 459 638
- US-A- 4 525 769
- US-A- 5 235 491

## Beschreibung

Die Erfindung betrifft eine Vorrichtung zur Entwärmung eines an einer Innenwand eines Gehäuses befestigten verlustbehafteten elektronischen Bauteils, bei welcher das Gehäuse an mehreren seiner Außen- und/oder Innenwände mit einem Kühlkörper kontaktiert ist.

Zur Entwärmung von verlustbehafteten elektronischen Bauteilen sind verschiedene Kühlmethoden bekannt. Die am häufigsten verwendete Methode ist eine Kühlung durch eine Konvektion, die von einem Lüfter unterstützt sein kann.

Weiterhin ist es zur Abführung der Verlustwärme von Leistungsbauelementen bereits bekannt, diese an einer Innenwand eines Gehäuses zu befestigen und die Verlustwärme über diese eine Gehäusewand abzuführen. Die genannte Gehäusewand ist dabei auf ihrer Außenseite mit einem Kühlkörper verbunden, über welchen die Wärme an die Umgebung abgeführt wird.

Aus der DE 27 22 142 A1 ist eine metallische Gehäusewandung für ein elektronische Bauelemente aufnehmendes Gehäuse bekannt. Die Gehäusewandung dieses bekannten Gehäuse ist mit außen aufgesetzten Halbleiterbauelementen bestückt. Ferner sind mit der Innen- und Außenseite der Gehäusewandung mehrere Kühlkörper kontaktiert.

Ausgehend von diesem Stand der Technik liegt der Erfindung die Aufgabe zugrunde, eine Vorrichtung zur Entwärmung eines an einer Innenwand eines Gehäuses befestigten verlustbehafteten elektronischen Bauteils anzugeben, bei welcher die Entwärmung verbessert ist.

Diese Aufgabe wird durch eine Vorrichtung mit den im Anspruch 1 angegebenen Merkmalen gelöst. Vorteilhafte Ausgestaltungen und Weiterbildungen der Erfindung ergeben sich aus den abhängigen Ansprüchen.

Die Vorteile der Erfindung bestehen insbesondere darin, daß die in dem elektronischen Bauteil entstehende Verlustwärme über einen Großteil der Gehäuseoberfläche oder gar die gesamte Gehäuseoberfläche an Kühlkörper weitergegeben und von diesen an die Umgebung abgeführt wird.

Durch die Verwendung eines im Innenraum des Gehäuses vorgesehenen Lüfters, der temperaturgeregelt sein kann, wird die Verteilung der Wärme im Inneren des Gehäuses verbessert und dadurch eine verbesserte Wärmeableitung über die vorhandenen Kühlkörper erreicht.

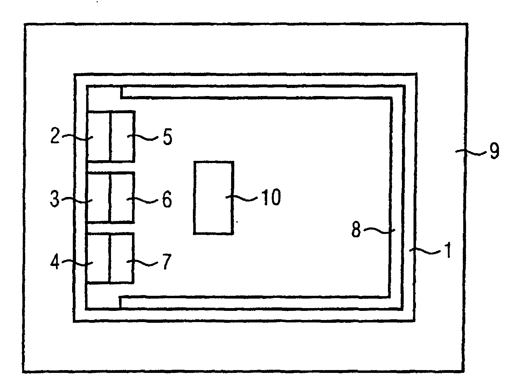

Weitere vorteilhafte Eigenschaften der Erfindung ergeben sich aus der Erläuterung eines Ausführungsbeispiels anhand der Figur.

Diese zeigt ein Gehäuse 1, welches insgesamt sechs Gehäusewände aufweist, von denen vier aus der Figur ersichtlich sind. Dabei handelt es sich um eine linke Seitenwand, eine rechte Seitenwand, eine obere Wand und eine untere Wand.

An der Innenseite der linken Seitenwand des Gehäuses 1 sind verlustbehaftete elektronische Bauteile 2, 3, 4 befestigt, bei denen es sich beispielsweise um Leistungshalbleiter handelt. Das Gehäuse 1 ist an mehreren seiner Außenseiten, vorzugsweise - wie in der Figur dargestellt - an vier seiner Außenseiten formschlüssig von einem oder mehreren Kühlkörpern 9 umgeben.

Die in den Leistungshalbleitern 2, 3, 4 entstehende Verlustwärme wird in die aus Aluminium-Druckguß bestehenden Gehäusewände geführt und über diese an den oder die Kühlkörper 9 weitergegeben, die die Gehäusewände an deren Außenseiten kontaktieren.

Durch diese großflächige Wärmeableitung unter Verwendung der gesamten Gehäuseoberfläche wird sowohl eine Beschleunigung der Entwärmung als auch eine Abführung einer höheren Wärmemenge erreicht.

Eine weitere Verbesserung der Wärmeableitung wird dadurch erreicht. daß die Leistungshalbleiter 2, 3, 4 jeweils an ihrer von der Gehäuseinnenseite abgelegenen Seite mit einem weiteren Kühlkörper 5, 6, 7 verbunden sind. Diese weiteren Kühlkörper 5, 6, 7 dienen dazu, die im jeweiligen Leistungshalbleiter 2, 3, 4 entstehende Verlustwärme in den Innenraum des Gehäuses 1 weiterzugeben. Dieser Innenraum steht über einen oder mehrere Kühlkörper 8, vorzugsweise ein Kühlkörperprofil, mit einer jeweils zugehörigen Innenwand des Gehäuses 1 in Verbindung. Dadurch wird die im Innenraum des geschlossen ausgebildeten Gehäuses 1 entstehende Wärme vom Kühlkörper 8 aufgenommen, von diesem aus an die Wände des Gehäuses 1 weitergegeben, dann an den oder die das Gehäuse umschließenden Kühlkörper 9 übertragen und von diesen aus an die Umgebung abgeführt.

Die Verteilung der in den Leistungshalbleitern 2, 3, 4 entstehenden Verlustwärme im Innenraum des Gehäuses kann durch eine Verwendung eines Lüfters 10 verbessert werden, der vorzugsweise temperaturgesteuert arbeitet. Überschreitet die im Innenraum des Gehäuses 1 gemessene Temperatur einen vorgegebenen Temperatur-Schwellenwert, dann wird der Lüfter 10 aktiviert und dadurch ein Luftstrom erzeugt, der die Wärme von den Kühlkörpern 5, 6, 7 zu dem an den Innenseiten des Gehäuses vorgesehenen Kühlkörper 8 transportiert. Von dort aus wird sie über das Gehäuse 1 und den oder die äußeren Kühlkörper 9 an die Umgebung abgeführt.

Durch die vorstehend beschriebene Vorrichtung entsteht ein Wärmetransport, der eine Verteilung der entstehenden Verlustwärme in das gesamte Gehäuse 1 ermöglicht. Dadurch kann zur Abgabe der Verlustwärme die gesamte Gehäuseoberfläche genutzt werden. Lediglich bestimmte Funktionsflächen des Gehäuses 1, beispielsweise Befestigungsflächen, Kabeleinführungsflächen, usw., bleiben von Kühlkörpern bzw. Kühlmedien frei.

## Patentansprüche

1. Vorrichtung zur Entwärmung eines an der Innenseite einer Wand eines Gehäuses befestigten verlustbehafteten elektronischen Bauteils, bei welcher das Gehäuse an mehreren seiner Außen- und/oder Innenwände mit einem Kühlkörper kontaktiert ist, **dadurch gekennzeichnet, daß** das verlustbehaftete elektronische Bauteil (2,3,4) an seiner von der Gehäuseinnenwand abgelegenen Seite mit einem weiteren Kühlkörper (5,6,7) kontaktiert ist.

2. Vorrichtung nach Anspruch 1, **dadurch gekennzeichnet, daß** die Gehäusewände aus Aluminium-Druckguß bestehen.

3. Vorrichtung nach Anspruch 1 oder 2, **dadurch gekennzeichnet, daß** das Gehäuse (1) an vier Seiten von einem oder mehreren Kühlkörper (9) formschlüssig umgeben ist.

4. Vorrichtung nach einem der vorhergehenden Ansprüche, **dadurch gekennzeichnet, daß** das verlustbehaftete elektronische Bauteil (2,3,4) an einer Innenwand des Gehäuses befestigt ist und an mehreren der weiteren Innenwände Kühlkörper (8) vorgesehen sind.

5. Vorrichtung nach einem der vorhergehenden Ansprüche, **dadurch gekennzeichnet, daß** an einer Innenwand des Gehäuses (1) mehrere verlustbehaftete elektronische Bauteile befestigt sind.

6. Vorrichtung nach einem der vorhergehenden Ansprüche, **dadurch gekennzeichnet, daß** im Innenraum des Gehäuses ein Lüfter (10) vorgesehen ist.

7. Vorrichtung nach Anspruch 6, **dadurch gekennzeichnet, daß** der Lüfter (10) temperaturabhängig steuerbar ist.

8. Vorrichtung nach einem der vorhergehenden Ansprüche, **dadurch gekennzeichnet, daß** jedes verlustbehaftete elektronische Bauteil (2,3,4) ein Halbleiterbauelement ist.

9. Vorrichtung nach Anspruch 8, **dadurch gekennzeichnet, daß** das Halbleiterbauelement ein Leistungshalbleiter ist.

## Claims

1. Device for dissipating heat from a lossy electronic component fixed to the inner side of a wall of a housing, in which several of the outer and/or inside walls of the housing are placed into contact with a cooling element, **characterised in that** the lossy electronic component (2, 3, 4) is placed into contact on its side remote from the inside wall of the housing with a further cooling element (5, 6, 7).

2. Device according to Claim 1, **characterised in that** the housing walls comprise an aluminium die-casting.

3. Device according to Claim 1 or 2, **characterised in that** the housing (1) is surrounded in a positively-engaging manner on four sides by one or more cooling elements (9).

4. Device according to one of the preceding claims, **characterised in that** the lossy electronic component (2, 3, 4) is fixed to an inside wall of the housing and is provided on several of the further inside walls with cooling elements (8).

5. Device according to one of the preceding claims, **characterised in that** several lossy electronic components are fixed to an inside wall of the housing (1).

6. Device according to one of the preceding claims, **characterised in that** a fan (10) is provided in the interior space of the housing.

7. Device according to Claim 6, **characterised in that** the fan (10) is controllable in a temperature-dependent manner.

8. Device according to one of the preceding claims, **characterised in that** each lossy electronic component (2, 3, 4) is a semiconductor device.

9. Device according to Claim 8, **characterised in that** the semiconductor device is a power semiconductor.

## Revendications

1. Dispositif pour dissiper de la chaleur d'un composant électronique sujet à des pertes et fixé sur la face intérieure d'une paroi d'un boîtier, dans lequel le boîtier est mis en contact sur plusieurs de ses parois extérieures et/ou intérieures avec un radiateur, **caractérisé en ce que** le composant (2, 3, 4) électronique sujet à des pertes est mis en contact sur son côté éloigné de la paroi intérieure du boîtier avec un autre radiateur (5, 6, 7).

2. Dispositif suivant la revendication 1, **caractérisé en ce que** les parois du boîtier sont en pièces coulées sous pression en aluminium.

3. Dispositif suivant la revendication 1 ou 2, **caractérisé en ce que** le boîtier (1) est entouré à complémentarité de forme sur quatre côtés d'un ou de plusieurs radiateurs (9).

4. Dispositif suivant l'une des revendications précédentes, **caractérisé en ce que** le composant (2, 3, 4) électronique sujet à des pertes est fixé sur une paroi intérieure du boîtier et il est prévu des radiateurs (8) sur plusieurs des autres parois intérieures.

5. Dispositif suivant l'une des revendications précédentes, **caractérisé en ce que** plusieurs composants électroniques sujets à des pertes sont fixés sur une paroi intérieure du boîtier (1).

6. Dispositif suivant l'une des revendications précédentes, **caractérisé en ce qu'**il est prévu un ventilateur (10) à l'intérieur du boîtier.

7. Dispositif suivant la revendication 6, **caractérisé en ce que** le ventilateur (10) peut être commandé en fonction de la température.

8. Dispositif suivant l'une des revendications précédentes, **caractérisé en ce que** chaque composant (2, 3, 4) électronique sujet à des pertes est un composant à semiconducteur.

9. Dispositif suivant la revendication 8, **caractérisé en ce que** le composant à semiconducteur est un semiconducteur de puissance.
